(19)

**Europäisches Patentamt**
**European Patent Office**
**Office européen des brevets**

(11)  **EP 1 808 704 A1**

(12)  **EUROPEAN PATENT APPLICATION**

(43) Date of publication:
**18.07.2007  Bulletin 2007/29**

(51) Int Cl.:
*G01R 33/30* (2006.01)    *G01R 33/34* (2006.01)

(21) Application number: **06075095.7**

(22) Date of filing: **16.01.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **Spinnovation Holding BV**
**6525 ED Nijmegen (NL)**

(72) Inventor: **The designation of the inventor has not yet been filed**

(74) Representative: **Winckels, Johannes Hubertus F. et al**
**Vereenigde**
**Johan de Wittlaan 7**
**2517 JR  Den Haag (NL)**

(54)  **MAS NMR method and apparatus**

(57)  The invention is in the field or Nuclear Magnetic Resonance spectroscopy, and mainly in the field of Magic Angle Spinning (MAS) techniques. The invention provides for a novel system for measuring and/or analyzing small samples with MAS/NMR techniques. Thereto a very small MAS-sample holder is provided, as well as various other measurement system members and method to perform high velocity spinning of the sample holder. Also the use of the system and/or one of its members is disclosed.

EP 1 808 704 A1

## Description

## Field of the invention

The invention is in the field of Nuclear Magnetic Resonance (NMR) spectroscopy, more specifically in the field of Magic Angle Spinning (MAS) techniques. The invention provides a novel system for measuring and/or analyzing very small samples (nL or µg scale) using MAS/NMR techniques. Also the use of the system and/or one of its members is disclosed.

## Background

### NMR signal detection limit and micro-coils

Nuclear Magnetic Resonance spectroscopy (NMR) has had a tremendous impact on research in physics, chemistry, biology and medicine (MRI). In chemistry and biology, it has become the method of choice for structure analysis because of the wealth of information that can be obtained at the atomic level. For example it allows for the extraction of inter-nuclear distances and coupling strengths within a molecule, giving access to its 3-dimensional configuration and functional behavior. In materials science, NMR is the method of choice for analyzing material atomic and/or molecular structure and physical properties.

Nevertheless NMR spectroscopy faces limitations that mainly relate to its rather low sensitivity. Only with the utmost care in noise reduction can the NMR signal be accumulated in a reasonable amount of time. Even then, the technique is only applicable for samples with relatively large concentrations of spins. For instance in NMR spectroscopy, typical sample sizes are of the order of 10-500 mm$^3$. In contrast to various other techniques one typically requires of the order of $10^{14}$-$10^{16}$ nuclei in the sample.

In analytic chemistry, the inherent low sensitivity of NMR systems severely limits its application as a routine in situ analysis tool. For instance, an improvement in sensitivity by a factor of 10 would bring the data acquisition times down from days to minutes and allow for example online quality control in chemical or pharmaceutical production.

In the past it has been shown that when the amount of sample is limited, sensitivity can be gained by decreasing the coil size in order to keep the filling factor as large as possible. This has led to the development and implementation of micro-coils especially in solution state NMR to study "limited size samples" and is at the origin of numerous papers and patents on "micro-coils developed for micro-fluidics" application. Yamauchi et al. (Journal of Magnetic Resonance 2004, 167, 87-96) have worked on micro-coil design that greatly increase the sensitivity that can be reached by a solid-state NMR probehead.

The basic equation that expresses the NMR signal to noise ratio is given by:

$$\frac{S}{N} = \frac{k_0\left(\frac{B_1}{i}\right)V_S N \gamma \hbar^2 I(I+1)\frac{\varpi_0^3}{k_g T 3\sqrt{2}}}{F\sqrt{4k_B T R_{\text{noise}}\Delta f}} \quad (I)$$

where $k_0$ is a scaling factor accounting for the rf (radio frequency) inhomogeneity of the coil, $B_1/i$ is the magnetic field induced in the rf coil per unit of current, $V_S$ the sample volume, $N$ the number of spins per unit volume, $\gamma$ the gyromagnetic ratio, $I$ the spin quantum number, $\omega_0$ the nuclear Larmor precession frequency, $T$ the temperature and $h$ and $k_B$ are Planck's and Boltzmann's constant, respectively. The denominator describes the noise, using the noise factor of the spectrometer ($F$), conductive losses of the coil, circuit and sample ($R_{\text{noise}}$) and the spectral bandwidth ($\Delta f$). In the derivation of this expression, it is assumed that the coil resistance, including sample losses, dominates the noise figures. An implicit assumption is that the noise of the preamplifier is negligible. In this case, the Q factor of the resonant LC circuit drops out of the problem, since signal and noise are both amplified by the same amount.

The assumption mentioned above may not be true any more if the noise is suppressed, as for example, in cryo-cooled detector coils. From the above equation, it is clear that most of the parameters are constants of nature or dictated by the sample properties or sample conditions such as temperature. The basic strategy to optimize the NMR signal is to choose the lowest possible temperature combined with the highest magnetic field (and thus rf) that is available. It has been widely accepted that cooling of the rf coil in so-called cryo-cooled probes is a sensible way to improve sensitivity. For pure metals, the resistivity is more or less linear in temperature, so a reduction in temperature by a factor of 10 may lead to reduction of about a factor three in the noise amplitude.

### Micro-coils

In order to be able to detect NMR signals from a relatively small sample volume (µL range), there have been recent attempts to construct NMR systems with smaller sample holders, and therefore also smaller coils have been developed. Nevertheless, they were all dedicated to samples in solution or other fluids, but a description how to perform NMR signal detection of samples in the solid-state is missing.

US-A-6 097 188 discloses an NMR apparatus comprising a fluid sample holder, which contains about 10 µL of sample and a micro-coil which has an inner diameter of about 1 000 µm.

US-A-6 788 061 provides for an NMR apparatus comprising a fluid sample holder with a sample holding void of less than about 1 µL, a coil, which encloses the containment region of the sample and a magnet to provide a static magnetic field. The system is claimed to provide an NMR spectrum with a spectral line width of less than about 0.1 parts per million (ppm).

US-A-6 822 454 discloses a microfluidic device with multiple micro-coil NMR system. It describes an NMR system that comprises an NMR probe with multiple NMR detection sites. Each of the multiple NMR detection sites comprises a sample holding void and an associated NMR micro-coil. The NMR system further comprises a controllable fluid router operative to direct fluid sample to the multiple NMR detection sites. The fluid analyte volume ranges from 0.1 $\mu$l to 1 $\mu$l.

As mentioned earlier, the use of micro-coils in NMR spectroscopy combined with MAS is, however, not disclosed in any of the above-mentioned documents.

MAS techniques

The majority of solid-state NMR experiments are performed while the sample is spun rapidly about an axis inclined at an angle of 54,74° with respect to the main axis of the applied external magnetic field. This angle is referred as "Magic Angle", and thus the technique is referred as "Magic Angle Spinning" or "MAS". This technique allows to efficiently average to their isotropic values the spatial dependency of many NMR interactions, such as dipolar coupling or chemical shift anisotropy. The use of MAS leads, in most cases, to significant increase in resolution and sensitivity.

**Brief description of the drawings**

Figure 1 shows on the left schematically the micro-MAS sample holder mounted on a regular macroscopic-spinner (rotor) in accordance with the present invention. On the right definitions of certain parameters are given that are used in describing the micro-MAS sample holder of the present invention.

Figure 2 is a schematic depiction of the overall design of the micro-coil implemented on a chip in accordance with the present invention.

Figure 3 schematically shows a configuration in accordance with the present invention, wherein the micro-coil chip is mounted on a platform fixed on the top part of the stator.

**Summary of the invention**

Combine micro-coil and MAS approach to improve sensitivity and resolution

It is sometimes not possible, or very difficult, to obtain sufficient quantities of sample necessary for measuring an NMR signal with reasonable signal-to-noise ratio. Due to the low sensitivity of state of the art systems, and also because no system is available for measurements of micro-scale solid samples, solid-state NMR analysis of such samples can not be achieved. Thus, in the state of the art there is a need for high resolution, high sensitivity NMR in order to be able to study e.g. mass or volume-limited samples (i.e. in the range of the $\mu$g or nL scale).

The present invention solves the above-mentioned problems, by improving the sensitivity of the NMR system due to the intrinsic lower detection limit of the micro-coil, by allowing the detection of NMR signal from nL scale quantity samples, and finally by allowing to perform all MAS/NMR experiments on the aforementioned samples. The MAS of the present invention greatly contributes to the increase in sensitivity and resolution compared to the prior art. Moreover, the system is also suitable to detect fluid/semi-fluid samples with low concentration due to the high sensitivity of the micro-coil system.

In accordance with the present invention the MAS technique is combined with detection of NMR signal using a probehead equipped with a micro-coil. The MAS system is based on a MAS macroscopic rotor (>1.0 mm in diameter) that supports the microscopic sample holder, and a standard MAS platform providing pneumatic drive and bearing. This design allows to achieve stable high-rate spinning (>10 kHz, with a variation of $\pm$1 Hz) of the micro-sample holder. The pneumatic drive and bearing are thus applied to the macroscopic spinner (also called rotor) which supports the micro-sample holder attached to its top part. The micro-MAS sample holder is thus able to be spun at high speed with very high stability, which can not be achieved using classical MAS system design such as disclosed in US-A-4 511 841.

The present inventors have developed various parts, such as a micro-probehead, comprising a micro-coil embedded into a resonant circuit and a micro-MAS sample holder. The new design of the NMR micro-probehead, micro-MAS sample holder and MAS system not only allows to perform MAS/NMR experiments on extremely small sample, but it also gives the new opportunity to combine the benefit of high-sensitivity of NMR micro-coils, with the increase of resolution and sensitivity achieved by using MAS for solid/semi-solid samples.

Overall advantages of the system and method

1) The micro-MAS sample holder according to the present invention is highly reduced in size as compared to a state-of-the-art MAS sample holder, enabling the measurement of smaller amounts/volumes. The resolution is improved by combining magic angle spinning and micro-coil detection. This reduction in size allows a much more sensitive detection of the NMR signals of mass limited samples. This sensitivity roughly scales with the inverse of the coil diameter, leading to an improvement of the sensitivity for a fixed (small) number of nuclei in the sample by a factor of 10.

2) Furthermore, by reducing the size of the MAS sample holder and thereby allowing the reduction in size of the coil used, also the excitation bandwidth has increased significantly. The excitation bandwidth in NMR scales linearly with the amplitude of the time-varying magnetic field in the *rf* coil. A reduction in size by a factor of ten allows a ten times higher excitation bandwidth compared to the reference MAS probe at the same amount of *rf* power. Conversely, the same excitation bandwidth can be achieved with a factor 100 lower power of the *rf* amplifier compared to the state of the art. High *rf* fields allow higher decoupling efficiency for e.g. $^{13}C$, $^{15}N$ nuclei coupled to protons, leading to better resolution spectra for these nuclei compared to the state of the art.

3) The speed in MAS is limited by the centrifugal forces on the rotor material, as well as on the sample. This force is given by $F_c = m\omega^2 r$, where $\omega$ is the angular frequency, *m* is the mass and r is the radius. For example, a sample in a rotor with a radius of 1 cm spinning at 2 kHz experiences a maximum centrifugal force of $1.6 \cdot 10^5$ times the gravitational force. In the present design, the centrifugal force on the sample is reduced by a factor 100 at the same spinning speed. Conversely, the design allows a separate optimization of the MAS turbine or rotor, in terms of size and material, to achieve the highest possible rotation speed, while at the same time the sample holder size and material can be optimized for NMR applications. The smaller diameter of the micro-MAS sample holder allows the use of lower strength material that has less *rf* heating and contains less impurities as compared to state-of-the-art MAS rotors.

4) At present micro-coils are used in micro fluidic applications. However, the distortion in the magnetic field due to the susceptibility of the *rf* coil material increases substantially if the coil windings are close to the sample. This limits the resolution that can be obtained in these applications. With fast sample spinning the susceptibility broadening is averaged out and high resolutions can be obtained. In principle, the higher spinning speeds can even improve the resolution compared to state-of-the-art NMR systems.

5) A major problem in MAS of biological specimen or other inhomogeneous conducting samples is the heating caused by Eddy currents in the rotating sample. In conducting samples, the heating is roughly proportional to $r^4$, where *r* is the typical diameter of the conducting path. Reducing the sample diameter reduces this problem because the Eddy current heating is much lower, and the heat diffusion length to the (cooled) surface of the rotor is much shorter.

6) In the micro-coil assembly the *rf* current to generate the same excitation field as in a regular coil can be much lower, leading to a smaller potential drop over the coil. The *rf* electric field in the sample will then be of the same magnitude as in a macroscopic sample, however as in the previous point, the cooling can be more effective, leading to better controlled temperatures in the sample.

7) Frictional heating in a MAS probe occurs primarily at the bearing between rotor and stator. In the present design, the sample is well separated from the bearing and separate cooling strongly reduces the effect of frictional heating compared to the state of the art system.

## Applications

With the present measurement system it is now possible to measure or analyze samples relating to a wide range of potential applications, which can not be measured or analyzed with presently available systems. Examples of potential applications are given below.

1) Rare, precious solid crystalline material. In many cases one may encounter small sample volumes as in forensic applications, samples with special isotopic constitution, thin epitaxial layers, nanocrystals etc. where it is either difficult or very expensive to collect a homogeneous sample of the order of a milliliter in volume. Note that for example other analytical methods may work with much smaller samples, although that may be destructive in nature. Furthermore, often a direct NMR comparison on the same sample is not possible. The present method allows for the highest sensitivity NMR analysis available for sub-μL samples, without compromising the resolution or versatility of the NMR method.

2) Biological and/or isotopically enriched samples. A problem in NMR is that not all isotopes of the nuclei have suitable spin properties. One of the methods in biochemical NMR is to use samples enriched in for example $^2D$, $^{13}C$, $^{15}N$ or $^{17}O$. In some cases there are appropriate synthesis routes for such samples and although still expensive, these samples can be produced in sufficient quantities to be analyzed with the inventive measurement system. In other cases, like tissue of living organisms or for example natural silk it is much more difficult to produce a uniform sample. Thus, with the present technique one can for the first time study single fibers of silk or other biomaterials.

3) In many situations it is important to study surface or interface properties. For example in bio-mineralization, reconstruction of bone fractures or teeth surface, it is important to study the structure and composition of the first layers that are deposited. In this case the total sample volume will be small and the present method may substantially increase the chance of successful NMR analysis.

4) Some microorganisms or individual cells are of a size that individual items can be studied by the present micro-MAS NMR-spectroscopy. For example one can envision the study of a single cell nucleus and follow the metabolism in a single cell, rather than that of a relatively large ensemble of cells that are in different stages of development.

5) The special thermal properties and low dielectric heating in the present MAS/NMR system allows for the study of proteins or other biomaterials that deteriorate under normal NMR investigations.

6) In biomedical clinical investigation of for example cancer tissue one requires a fair amount of sample to perform a decisive screening on malignant tumor cells. With the present design one can envision the study of 100 micrometer size biopsies that can be obtained in a much less invasive and traumatic operation on the patient. This may lead to a less painful operation and less side effects.

7) MAS/NMR investigation of inhomogeneous metallic compounds is strongly hindered by the Eddy current heating. For example in metal hydrides this may lead to release of hydrogen gas and a potentially dangerous explosion of the MAS rotor. In small diameter MAS one can substantially reduce the Eddy current problem and allow for the first time NMR investigation of this important class of material.

8) High field inhomogeneous (resistive) magnets are potentially important to enhance sensitivity and resolution in materials with quadrupolar nuclei. A problem limiting their routine application is the inhomogeneity of the static field. With the present micro MAS this problem is reduced, and one may expect roughly a factor 10 enhancements in resolution.

9) The application of NMR analysis is limited to specialized laboratories because of the expensive cryogenic magnets that are involved. With permanent magnets one can reach sufficient field strength, but the homogeneity in field generally does not allow spectroscopy with a reasonable resolution. The present MAS/NMR-system is much less sensitive to this inhomogeneity and opens a promising road to table-top inexpensive MAS/NMR spectroscopy. In addition, the low *rf* power operation allows a simple pc based data acquisition without the expensive *rf* amplifiers that are needed for conventional NMR.

In a first aspect the invention relates to a measurement system comprising:

a. an *NMR-spectroscopy system* including a probehead comprising a micro-coil for detection of NMR signal

b. a *MAS-system* for use with the NMR-spectroscopy system, and

c. a *micro-MAS sample holder,* characterized in that the micro-MAS sample holder has a diameter of less than 1 000 $\mu$m, preferably in a range of 10 $\mu$m to 500 $\mu$m, more preferably in a range of 15 $\mu$m to 200 $\mu$m.

With the term "NMR-spectroscopy-system", in the present application, each system is meant that is capable of performing NMR measurements, which performance is indicated above and is further well known to the person skilled in the art.

With the term "MAS-system" in the present application, each system is meant that is capable of analyzing or measuring a sample or object, rotating at the so-called "Magic Angle" (54,74°) with respect to the axis of the external magnetic field. In this respect, reference is made to the US patent US 4,511,841, in which a MAS-system is disclosed.

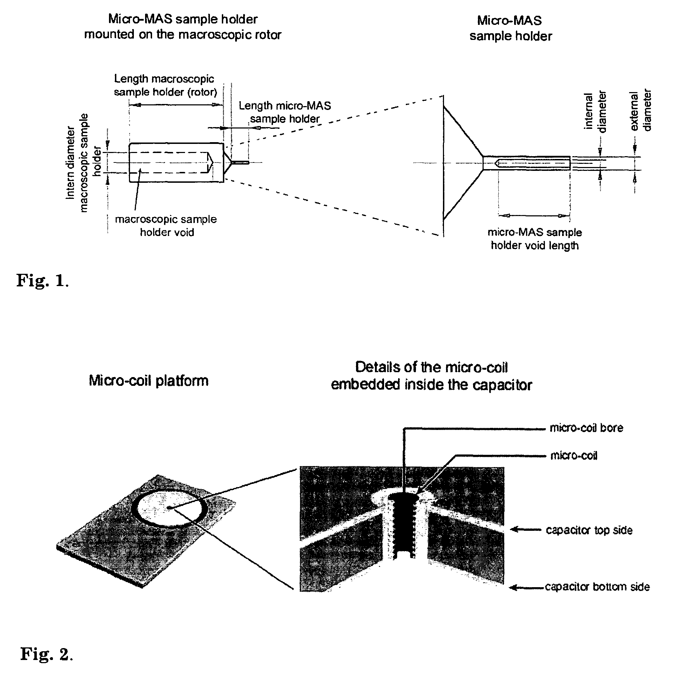

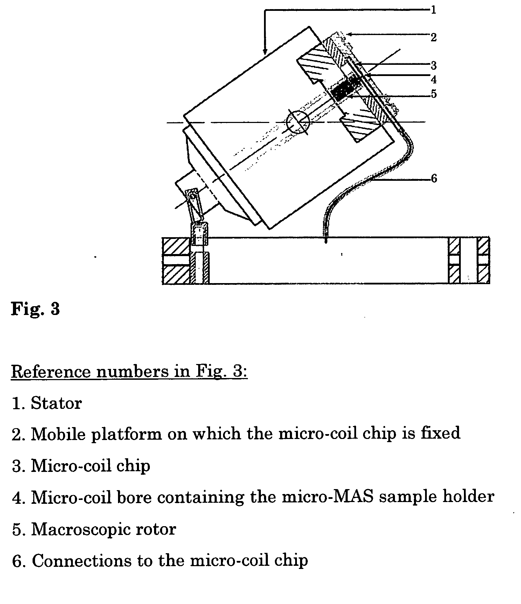

With the term "micro-MAS sample holder", a holder is meant that may contain a sample or object to be analyzed or measured. The form of the holder is preferably a cylindrical element, such as a cylinder, supplied with an opening, such as a round bottom flask. The micro-MAS sample holder is attached or interdependent to the top part of the macroscopic rotor (see Figure 1) on which the pneumatic drive and bearing are applied, this at least when performing MAS/NMR experiment.

In a further aspect the invention relates to a micro-MAS sample holder with an outer diameter of less than 1 000 $\mu$m, preferably less than 500 $\mu$m, more preferably less than 250 $\mu$m. Normally the outer diameter of the sample holder is more than 10 $\mu$m.

The length of the micro-MAS sample holder is amongst others determined by other elements of the system in order to fit operationally into the system. Conveniently the micro-MAS sample holder has a length of 500 to 5 000 $\mu$m, preferably a length of 600 to 2 000 $\mu$m, and more preferably a length of 700 to 1 000 $\mu$m.

In a preferred embodiment the present micro-MAS sample holder has an inner volume of less than 100 nL, preferably less than 10 nL and more than 0.1 nL. The micro-MAS-sample holder preferably has a wall with a thickness of 5 $\mu$m to 50 $\mu$m, more preferably with a thickness of from 10 $\mu$m to 30 $\mu$m. It is advantageous to choose the thickness within the limits mentioned above, e.g. for mechanical reasons.

The micro-MAS-sample holder is preferably made of a material chosen from the group of materials with high resistance properties to physical and/or chemical constraints, and/or temperature variations, which constraints and variations typically relate to the envisaged application. For instance, this material is typically chosen from the group consisting of Vespel® (DuPont).

In another aspect the invention relates to a NMR micro-coil platform for use in a system according to the invention.

The coil of the present invention has a preferred inner diameter of less than 1 000 $\mu$m, preferably 250 $\mu$m. Normally the inner diameter of the coil is more than 10 $\mu$m. In cases wherein the coil is very small, also the term "micro-coil" or "$\mu$-coil" may be used.

With the term "coil" in the present application an inductor is meant e.g. for use in an NMR system, which coil further may also act as a receiver, i.e. as a detector.

In yet another preferred embodiment the present measurement system is composed of a micro-coil (inductor) integrated into a complete *rf* resonance system, the inductor being embedded inside the capacitor. This micro-coil design is disclosed in the article published by Yamauchi *et al.* (2004). This micro-coil design provides an improved mechanical stability to the coil. Therefore, it is not only much easier to change samples, as, in the present case, the risk of damaging a small coil is much less, but also the integrity of the coil is much better preserved over time, whereby a much more stable and reliable performance of the measurement system is achieved.

In yet a further aspect the invention relates to a high rotational velocity spinner, wherein the spinner in operation spins with a frequency of typically 1 Hz to 100 kHz, preferably from 1 kHz to 50 kHz. The term spinner refers to the aforementioned micro-MAS sample holder mounted on- or interdependent to a macroscopic sample holder also called rotor. With the term "high rotational velocity" in the present application a high angular velocity or frequency (number of revolutions per second) is meant with which a sample or object to be analyzed or measured rotates or spins.

In a preferred embodiment, the frequency with which the sample or object to be analyzed or measured in the micro-MAS sample holder rotates is from 1 to 100 kHz, preferably from 2 to 50 kHz and more preferably from 5 to 20 kHz. Such a high rotational velocity spinner provides further advantages. Amongst others, higher spinning rates improve significantly the resolution and signal-to-noise ratio of the NMR measurement performed on solid/semi-solid material.

In yet another preferred embodiment the present measurement system further comprises a pneumatic system providing drive and bearing directly acting on the macroscopic rotor to provide high velocity spinning rate with high stability. With the term "pneumatic drive" in the present application, a drive is meant that in this case rotates the macroscopic rotor around its main longitudinal axis, using pressurized gas as a driving entity. With the term "pneumatic bearing "in the present application pressurized air is meant to provide lift and prevent the macroscopic rotor from friction with the surrounding stator in which the rotor is placed. An example of a pneumatic drive and bearing from the state of the art is disclosed in US-A-4 511 841.

The spinner design comprising a macroscopic rotor, to which pneumatic drive and bearing are applied, surmounted by a coaxially aligned micro-MAS sample holder, reinsured significant reduction of friction and the thereby caused heating to the micro-MAS sample holder and thus to its contained sample or object.

In another aspect the invention relates to an optical approach to achieve alignment of the micro-MAS sample holder axis with the micro-coil bore axis. This constitutes the ultimate requisite step to achieve insertion, with minimal tolerances, of the micro-MAS sample holder in the micro-coil bore, avoiding mechanical contact between the two parts, in order to subsequently perform high velocity spinning of the micro-MAS sample holder inserted in the micro-coil bore and/or perform NMR measurement or analysis.

The alignment is performed considering the following the steps of

> ➢ providing a macroscopic MAS rotor with a small hole on its top base part, aligned with the rotor axis, such that light can pass through,
> ➢ providing a light source fitted in the rotor and/or passing through the hole of the rotor top base,
> ➢ providing an *rf* coil fixed or interdependent to a mobile platform,
> ➢ moving the *rf* coil platform orthogonally to the *rf* coil axis in order to align the *rf* coil bore with the exact position of the light source passing through the main axis of the underlying macroscopic rotor.

With the term "align" in the present application the process is meant which has as object to position and/or orient two or more elements with respect to each other.

With the term "minimal tolerances" in the present application it is meant that the relative positions of two or more elements with respect to each other are well defined, for example within 50 $\mu$m, preferably within 25 $\mu$m, more preferably within 10 $\mu$m, and most preferably within 5 $\mu$m.

With the term "optical approach" it is meant that with the use of light, preferably a laser, the centers of the coil and MAS sample holder are aligned, preferably controlled by using a microscope. When aligned, the light passes exactly through the center holes of both the sample holder and coil. Detection of the light passing through thus indicates that the sample holder and coil are aligned. The accuracy of alignment thus obtained is much better than that available in the state of the art, e.g. the accuracy obtained by the invention is in the order of 1 $\mu$m, preferably in the order of 0.1 $\mu$m.

In a preferred embodiment a platform was used to determine the exact alignment position. On one hand, this platform can be fitted tightly to the underlying stator which contains the macroscopic rotor. On an other hand, one part of the platform, to which the resonating system containing the micro-coil is fitted, is mobile and can be manipulated quite easily by conventional means. Therefore, the platform, and thereby the coil, can be moved very accurately with e.g. mechanical means, such as a stage. When the sample holder and coil are aligned, the mobile part of the platform is preferably fixed, e.g. by screws. The complete platform is then disconnected from the stator to allow the light source to be removed. The micro-MAS sample holder can then be fitted to a macroscopic rotor, preferably the one used during the alignment procedure, and introduced in the stator. The platform is then re-fitted to the stator into the fixed position predefined from the alignment procedure.

The rotor, and thus the micro-MAS sample holder, is then allowed to start spinning which helps to properly centre the sample holder in the axis of the coil. The whole micro-coil platform is then moved down along the main axis of the coil to its final position. When the micro-MAS sample holder is properly inserted in the coil, the spinning can be stopped and the whole probe can be inserted in the magnet to perform NMR measurement.

In a yet a further aspect the invention relates to a method to perform continuous external reference monitoring which is made possible by the new design of the sample holder as described in this invention. In present state of the art of MAS NMR, a reference sample such as KBr is used to optimize or verify the proper angle setting of the rotor. In the present invention it is proposed to use the spatially separated macroscopic sample holder of the MAS rotor to perform the alignment *in situ*. Alternatively, one can use this separate sample measurement channel as a reference for the micro-MAS experiment. For example, in a permanent magnet assembly, one of the main problems is the temperature induced field drifts. With the reference signal one can compensate electronically for this drift or computationally correct for the drift using a deconvolution method. The combination of small volume MAS (compensating for spatial field variations) with internal reference deconvolution (compensating for field variations in time) may allow for the first time versatile solid state NMR spectroscopy in table top magnets based on permanent magnetic materials or compact superconducting or normal coils.

In another aspect the invention relates to the use of any one member of the group consisting of a system and method according to the invention, a micro-MAS sample holder according to the invention, a spinner according to the invention, a high rotational velocity spinner according to the invention, a micro-coil according to the invention, an alignment method according to the invention, an integrated *rf* resonance system according to the invention and a pneumatic drive and bearing device according to the invention, preferably for detecting and/or analyzing a sample chosen from the group of solid state samples, liquid samples, surface samples, microbiological samples and other biological samples.

Such use provides the above-mentioned advantages.

Furthermore, it is now possible to measure or analyze a wide range of potential samples, which can not be measured or analyzed with presently available systems.

The invention further relates to the use of any one member of the group mentioned above, for measuring or analyzing e.g. small samples of rare, precious materials, with the highest sensitivity NMR analysis available, biological and/or isotopically enriched samples, to study surface or interface properties or microorganisms or individual cells, to study proteins or other bio materials that deteriorate under normal NMR investigations, to study 100 $\mu$m size or smaller biopsies, to investigate of inhomogeneous metallic compounds, to enhance sensitivity and resolution when studying materials containing quadrupolar nuclei.

The invention also relates to the use of any one member of the group mentioned above to be used in combination- or implemented in some table-top inexpensive NMR spectroscopy with a simple PC based data acquisition.

**Examples**

The invention is further described by the following examples, which are not meant to limit the scope of the invention in any way.

**EXAMPLE 1** Implementation of micro-coil on MAS platform

The micro-coil is fixed on a chip, embedded inside a capacitor (see Figure 2). The micro-coil chip is fixed to a mobile platform, which is connected to the stator (see Figure 3).

The stator provides the sample support and pneumatic drive and provides bearing for high velocity spinning.

One could manipulate the mobile platform in order to position the micro-coil bore in the axis of the micro-MAS sample holder, before the latest get inserted in the micro-coil bore.

**EXAMPLE 2** Design of spinner and production thereof.

Below the design of the spinner and production thereof is described in more detail.

The prototype spinner was based on the body of a commercially available rotor. The drive-tip closes one side of the rotor cylinder. The spinning was achieved by blowing high-pressurized air (or other gas such as $N_2$) on the driving-tip, while the air-bearing insures stability and avoids friction with the surrounding coil and stator: i.e. the spinning was achieved just as in any commercially available Magic Angle Spinning system, according to state-of-the-art.

The other top part of the rotor cylinder was closed with a cap in which a micro-MAS sample holder is embedded (see Figure 1). The cap and micro-MAS sample holder are interdependent. They were built from a single piece of material. The material used was typically Vespel® (Dupont), or any material with high resistance properties to mechanical and/or chemical constraints and/or high-amplitude temperature variations. The cap, including its container-tip extension, was produced on a lathe using a diamante blade to cut the hard material. The bore of the container was finally obtained by drilling a hole of suitable size in the cap extension.

**EXAMPLE 3** Micro-coil

The micro-coil used for excitation and detection of the NMR signal was embedded in the capacitor (see Figure 2). The design, principle and properties of the micro-coil relate to previously published work by Yamauchi et al. (Journal of Magnetic Resonance 2004, 167 (1), 87-96).

The system was mounted/implemented in any type of probe (Wide or Narrow bore). The principles of the probe design remain identical to any commercially available MAS probe.

**EXAMPLE 4** Alignment of the spinner and micro-coil.

Alignment of the micro-MAS sample holder with the micro-coil bore has to be performed with great care. First, the micro-coil mounted on a chip was fixed to the top part of the stator (see Figure 3). In the embodiment of Figure 3 a configuration in accordance with the present invention is depicted, wherein the micro-coil chip is mounted on a platform fixed on the top part of the stator. This platform can be moved orthogonally and axially respect to the micro-coil main axis. This mobility allows fine-tuning of the micro-coil bore position respect to the micro-MAS sample holder by sliding the chip in any direction of the platform plan. During the alignment procedure, a light source is placed in the macroscopic rotor, to indicate position of the main axis of the micro-MAS sample holder, and thus align the micro-coil bore respect to it.

The alignment of the micro-coil bore with the exact position of the micro-MAS sample holder was achieved by moving the micro-coil chip attached to a mobile platform. The alignment was based on an optical approach.

To align the coil, the same macroscopic rotor was used, however the micro-MAS sample holder was replaced by a normal cap in which a hole (with a slightly smaller diameter as the micro-coil bore) has been drilled in the center. A light source (diode + battery) was placed in the macroscopic rotor with the drilled-cap on top. The rotor was inserted in the stator and the micro-coil chip in the mobile platform was fixed to the top part of the stator. The platform was shifted until the light source passed trough the exact micro-coil bore position. This procedure was performed using a microscope. The position was locked with a set of screws. The platform was removed from the stator, the light source was removed and the rotor cap was switched with the micro-MAS sample holder.

The rotor was inserted in the stator and the micro-coil platform was mounted on top of the stator. A sliding system allows the platform to be now shifted away vertically from the stator such that the micro-MAS sample holder remains away from the micro-coil bore. The spinner was then allowed to start spinning which helped to properly center the micro-container. The whole micro-coil platform was then moved down to its final position. When the micro-MAS sample holder was properly inserted in the coil, the spinning was stopped and the whole probe was inserted in the magnet.

The spinning rates that were reached were identical to commercially available MAS systems with no specific limitation (for instance >10 kHz).

**EXAMPLE 5** Design of the spinner and production

The spinner of the present invention was based on the body of a commercially available 4 mm spinner. The drive-tip closed one side of the spinner cylinder. The spinning was achieved by blowing high-pressurized air (or other gas such as $N_2$) on the driving-tip while the air-bearing insured stability and avoided friction with the surrounding coil and stator: i.e. the spinning was achieved just as in any commercially available Magic Angle Spinning system.

The other top part of the spinner cylinder was closed with a cap in which a micro-container was embedded (see Figure 1). The cap and micro-container are interdependent. They are built from a single piece of material. The material used was Vespel® (Dupont), which material has high resistance properties to physical or chemical constraints or temperature variations. The cap, including its container-tip extension, was produced on a lathe using a diamond blade to cut the material. The bore of the container was finally obtained by drilling a hole of suitable size in the cap extension.

**EXAMPLE 6** Internal referencing

As the micro-coil system was independent to the lower part of the stator, a normal coil system was present and was hooked up to a different channel of the spectrometer. This allowed for instance to perform the optimization of the magic angle using KBr contained in the macro-spinner.

Also, this allows for instance to perform reference deconvolution in the case of inhomogeneous or time varying fields (Haase J. et al. Solid State NMR 2005, 27(3), 206-208).

**Claims**

1. A measurement system comprising

   a. a Nuclear Magnetic Resonance spectroscopy system, including a Nuclear Magnetic Resonance excitation circuit and Nuclear Magnetic Resonance detection circuit,
   b. a Magical Angle Spinning system for use with the Nuclear Magnetic Resonance spectroscopy system, and
   c. a Magical Angle Spinning sample holder for use in the Magical Angle Spinning system,

**characterized in that** the Magical Angle Spinning sample holder has a diameter of less than 1000 $\mu$m.

2. A system according to claim 1, wherein the Magical Angle Spinning sample holder has a diameter of less than 450 $\mu$m, preferably 10 - 250 $\mu$m, and more preferably 20 - 100 $\mu$m.

3. A system according to any one of claims 1-2, wherein the Magical Angle Spinning sample holder has a volume of less than 50 nL, preferably 0.1 - 10 nL.

4. A system according to any one of claims 1-3, which further comprises a micro-coil with a diameter of less than 1 000 $\mu$m, preferably 10 - 500 $\mu$m and more preferably 20 - 300 $\mu$m.

5. A system according to any one of claims 1-4, which further comprises an integrated radio frequency resonance system comprising a radio frequency inductor and a capacitor, whereby the radio frequency inductor is incorporated within the capacitor.

6. A system according to any one of claims 1-5, which further comprises a high rotational velocity spinner.

7. A system according to claim 6, wherein the spinner spins in operation with a frequency of at least 1 000 Hz.

8. A system according to claim 7, wherein the spinner spins in operation with a frequency of 2 to 100 kHz, preferably from 5 to 50 kHz.

9. A system according to any one of claims 1-8, which further comprises a pneumatic drive and bearing device, which pneumatic drive and bearing device are axially separated from the Nuclear Magnetic Resonance excitation and detection circuit, for driving the Magical Angle Spinning sample holder.

10. A Magical Angle Spinning sample holder for use in a system according any one of claims 1-9, which Magical Angle Spinning sample holder has a diameter of less than 1 000 $\mu$m, preferably 10 - 450 $\mu$m, more preferably 20 - 200 $\mu$m, and most preferably 30 - 100 $\mu$m.

11. A Magical Angle Spinning sample holder for use in a system according any one of claims 1-9, which Magical Angle Spinning sample holder has a volume of less than 50 nL, preferably 0.1- 10 nL.

12. The Magical Angle Spinning sample holder according to any one of claims 10 or 11, constructed of a material chosen from the group of materials with high resistance properties to physical and/or chemical constraints, and/or temperature variations.

13. A high rotational velocity spinner for use in a system according any one of claims 1-9.

14. A coil for use in a system according any one of claims 1-9, with a diameter of less than 1 000 $\mu$m, preferably 10 - 500 $\mu$m and more preferably 20 - 300 $\mu$m.

15. An alignment platform to align the micro-sample holder with the micro-coil bore for use in a system according any one of claims 1-9.

16. A high rotational velocity spinner for use in a system according any one of claims 1-9, which spinner spins in operation with a frequency of at least 1 000 Hz.

17. A high rotational velocity spinner according to claim 16, wherein the spinner spins in operation with a frequency of from 1 to 100 kHz, preferably from 5 to 50 kHz.

18. An integrated radio frequency resonance system for use in the system according to any one of claims 1-9, comprising a radio frequency inductor and a capacitor, whereby the radio frequency inductor is embedded in the capacitor.

19. A pneumatic drive and bearing device for use in the system according to any one of claims 1-9, which pneumatic drive and bearing device are axially separated from the Nuclear Magnetic Resonance excitation and detection circuit, for driving the Magical Angle Spinning sample holder according to any one of claims 10-12.

20. Use of any one member of the group consisting of a system according to any one of claims 1-9, a Magical Angle Spinning sample holder according to any one of claims 10-12, a high rotational velocity spinner according to claim 13, a coil according to claim 14, an optimizer according to claim 15, a spinner according to any one of claims 16-17, a integrated radio frequency resonance system according to claim 18 and a pneumatic drive and bearing device according to claim 19 for detecting and/or analyzing a sample chosen from the group consisting of solid state samples, liquid samples, surface samples, microbiological samples and other biological samples.

21. Method for aligning a Magical Angle Spinning rotor with a radio frequency coil, with minimal tolerances and to avoid mechanical contact between the two parts, comprising the steps of

   a. providing a Magical Angle Spinning rotor and a radio frequency coil,
   b. moving the Magical Angle Spinning rotor into the radio frequency coil, **characterized in that** the Magical Angle Spinning rotor comprises a hole in the center of the rotor cap, and
c. aligning the rotor with the coil by an optically controlled approach.

**22.** A method for performing continuous/semi-continuous external referencing comprising the steps of performing an in situ alignment with the spatially separated macroscopic sample holder of a Magic Angle Spinning rotor.

Micro-MAS sample holder
mounted on the macroscopic rotor

Micro-MAS
sample holder

Length macroscopic
sample holder (rotor)

Length micro-MAS
sample holder

internal diameter

external diameter

Intern diameter macroscopic sample holder

macroscopic sample
holder void

micro-MAS sample
holder void length

**Fig. 1.**

Micro-coil platform

Details of the micro-coil
embedded inside the capacitor

micro-coil bore

micro-coil

capacitor top side

capacitor bottom side

**Fig. 2.**

**Fig. 3**

Reference numbers in Fig. 3:

1. Stator

2. Mobile platform on which the micro-coil chip is fixed

3. Micro-coil chip

4. Micro-coil bore containing the micro-MAS sample holder

5. Macroscopic rotor

6. Connections to the micro-coil chip

European Patent Office

**EUROPEAN SEARCH REPORT**

Application Number

EP 06 07 5095

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YAMAUCHI K ET AL: "Implementing solenoid microcoils for wide-line solid-state NMR" JOURNAL OF MAGNETIC RESONANCE ACADEMIC PRESS USA, vol. 167, no. 1, March 2004 (2004-03), pages 87-96, XP004491644 ISSN: 1090-7807 * the whole document * | 1-22 | INV. G01R33/30 ADD. G01R33/34 |
| X | BALTISBERGER J H ET AL: "Multi-dimensional magnetic resonance imaging in a stray magnetic field" JOURNAL OF MAGNETIC RESONANCE ACADEMIC PRESS USA, vol. 172, no. 1, January 2005 (2005-01), pages 79-84, XP004697963 ISSN: 1090-7807 * page 80, left-hand column, paragraph 2; figure 3 * | 1-4, 10-15,20 | |
| X | US 6 326 787 B1 (COWGILL DONALD F [US]) 4 December 2001 (2001-12-04) * column 1, line 66 - line 48 * * column 4, line 13 - line 18 * * column 5, line 14 - line 48; claims 1,2 * | 1-22 | TECHNICAL FIELDS SEARCHED (IPC) G01R |
| X | STRINGER JOHN A ET AL: "Reduction of RF-induced sample heating with a scroll coil resonator structure for solid-state NMR probes" J. MAGN. RESON.; JOURNAL OF MAGNETIC RESONANCE MARCH 2005, vol. 173, no. 1, March 2005 (2005-03), pages 40-48, XP004738993 * the whole document * | 1-22 | |

-/--

The present search report has been drawn up for all claims

| Place of search | Date of completion of the search | Examiner |
|---|---|---|
| Munich | 15 January 2007 | Skalla, Jörg |

EPO FORM 1503 03.82 (P04C01)

**European Patent Office**

**EUROPEAN SEARCH REPORT**

Application Number

EP 06 07 5095

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | VAN BENTUM P J M ET AL: "Towards nuclear magnetic resonance [mu]-spectroscopy and [mu]-imaging" ANALYST 2004 UNITED KINGDOM, vol. 129, no. 9, 2004, pages 793-803, XP009077035 ISSN: 0003-2654 * page 795, left-hand column, paragraph 6; figures 1,4 * | 1-22 | |
| | ----- | | |
| T | JANSSEN H ET AL: "Microcoil high-resolution magic angle spinning NMR spectroscopy" JOURNAL OF THE AMERICAN CHEMICAL SOCIETY 12 JUL 2006 UNITED STATES, vol. 128, no. 27, 12 July 2006 (2006-07-12), pages 8722-8723, XP002414599 ISSN: 0002-7863 * the whole document * | 1-22 | |
| | ----- | | TECHNICAL FIELDS SEARCHED (IPC) |

The present search report has been drawn up for all claims

| Place of search | Date of completion of the search | Examiner |
|---|---|---|
| Munich | 15 January 2007 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 06 07 5095

This annex lists the patent family members relating to the patent documents cited in the above-mentioned European search report.
The members are as contained in the European Patent Office EDP file on
The European Patent Office is in no way liable for these particulars which are merely given for the purpose of information.

15-01-2007

| Patent document cited in search report | Publication date | Patent family member(s) | Publication date |
|---|---|---|---|
| US 6326787 B1 | 04-12-2001 | NONE | |

For more details about this annex : see Official Journal of the European Patent Office, No. 12/82

EPO FORM P0459

**REFERENCES CITED IN THE DESCRIPTION**

**Patent documents cited in the description**

- US 6097188 A
- US 6788061 A
- US 6822454 A
- US 4511841 A

**Non-patent literature cited in the description**

- **YAMAUCHI et al.** *Journal of Magnetic Resonance,* 2004, vol. 167, 87-96
- **YAMAUCHI et al.** *Journal of Magnetic Resonance,* 2004, vol. 167 (1), 87-96
- **HAASE J. et al.** *Solid State NMR,* 2005, vol. 27 (3), 206-208